# FASCICULE DE BREVET EUROPEEN

(11) **EP 1 411 143 B1**
(45) Date de publication et mention de la délivrance du brevet: **18.07.2007**
(21) Numéro de dépôt: 02405877.8
(22) Date de dépôt: 14.10.2002
(51) Int. Cl.: C23C 16/04, C23C 16/27, C23C 16/01

(54) **Procédé de fabrication de pieces tubulaires avec revêtement interne de diamant**
Verfahren zum Herstellung von rohrförmigen Hohlkörpern mit innenseitiger Diamantbeschichtung
Process for producing tubular pieces with an internal diamond coating

(43) Date de publication de la demande: 21.04.2004
(73) Titulaire: Adamant Technologies SA, 2300 La Chaux-de-Fonds (CH)
(72) Inventeur: Haenni, Werner, 2034 - Peseux (CH); Haefke, Henry, 4431 - Bennwil (CH)
(74) Mandataire: GLN

(56) Documents cités:
- EP-A- 0 467 634
- EP-A- 0 518 591
- EP-A- 0 562 764
- DE-C- 19 809 675
- FR-A- 2 790 267

## Description

La présente invention concerne un procédé de fabrication d'une pièce tubulaire dotée d'un revêtement interne de diamant et destinée à assurer l'écoulement d'un fluide quelconque, telle qu'une filière d'extrusion ou de tréfilage, une buse de découpage par jet d'eau ou un tube capillaire.

Des filières en diamant monocrystallin, possédant de très petits orifices (diamètre inférieur à 0.5 mm), sont utilisées depuis longtemps dans l'industrie pour le tréfilage de cuivre, aluminium, or, argent, platine, etc. et pour l'extrusion de polymères. Toutefois, du fait de son prix intrinsèque, du coût de son usinage ou même de l'impossibilité d'en trouver d'une taille suffisante, le diamant monocrystallin n'a pas été appliqué industriellement pour la réalisation de filières d'extrusion, de profilés métalliques ou de buses de découpage par jet d'eau à haute pression.

Des films minces de diamant polycristallin ont été déposés à l'intérieur et à l'extérieur de buses en céramique pour le découpage par jet d'eau à de très hautes pressions oscillantes (supérieures à 2 500 bars). Le problème est alors que les céramiques sont poreuses et ne présentent donc pas des surfaces parfaitement lisses, ce qui perturbe l'écoulement et affecte les propriétés et la cohérence du jet. Par ailleurs, sous de très hautes pressions, les céramiques deviennent solubles dans l'eau, ce qui limite considérablement leur durée de vie pour de telles applications.

Les producteurs et utilisateurs d'équipements de chromatographie en phase gazeuse ou liquide cherchent depuis longtemps à disposer de colonnes capillaires résistant à tous les types de produits analysés, indépendamment de leur valeur de pH. Or, les tubes actuellement disponibles résistent mal à des pH supérieurs à 8.

Le groupe de A. Fujishima de l'Université de Tokyo (Japon) a réalisé des réseaux de tubes capillaires formés d'aluminium poreux dans lequel du diamant a été déposé par CVD (Chemical Vapor Deposition). De tels réseaux peuvent, certes, être utilisés dans des échangeurs de chaleur mais ils ne conviennent pas pour les applications mentionnées ci-dessus.

La présente invention a pour but de fournir un procédé permettant de réaliser des filières d'extrusion ou de tréfilage, des buses de découpage par jet d'eau ou des tubes capillaires, qui ne souffrent pas des inconvénients énumérés ci-dessus.

De façon plus précise, l'invention concerne un procédé de fabrication d'une pièce tubulaire formant un canal revêtu de diamant, caractérisé en ce qu'il consiste à se doter d'une réplique dudit canal puis à effectuer les opérations de:
- dépôt d'une couche de diamant sur ladite réplique,
- dépôt d'une couche de céramique sur ladite couche de diamant, puis
- dissolution chimique de ladite réplique pour libérer ledit canal.

De préférence, préalablement au dépôt de la couche de diamant, la réplique est soumise à une opération de nitruration et/ou carburation destinée à former une couche superficielle constituant une barrière. Celle-ci permet d'éviter que le métal de la réplique ne diffuse dans la couche de diamant dont il sera recouvert et le déstructure en graphite ou carbone amorphe.

Il est avantageux que l'opération de nitruration et/ou carburation soit suivie d'une opération destinée à faciliter l'ancrage du diamant dans ladite couche barrière et que la couche de diamant soit formée par croissance de germes en atmosphère de gaz réactif.

D'autres caractéristiques de l'invention ressortiront de la description qui va suivre, faite en regard du dessin annexé, dans lequel :
- la figure 1 illustre, de a à e, les différentes étapes du procédé lorsqu'il est appliqué à la réalisation d'un tube capillaire, et
- la figure 2 montre que le procédé permet aussi de réaliser une filière ou une buse.

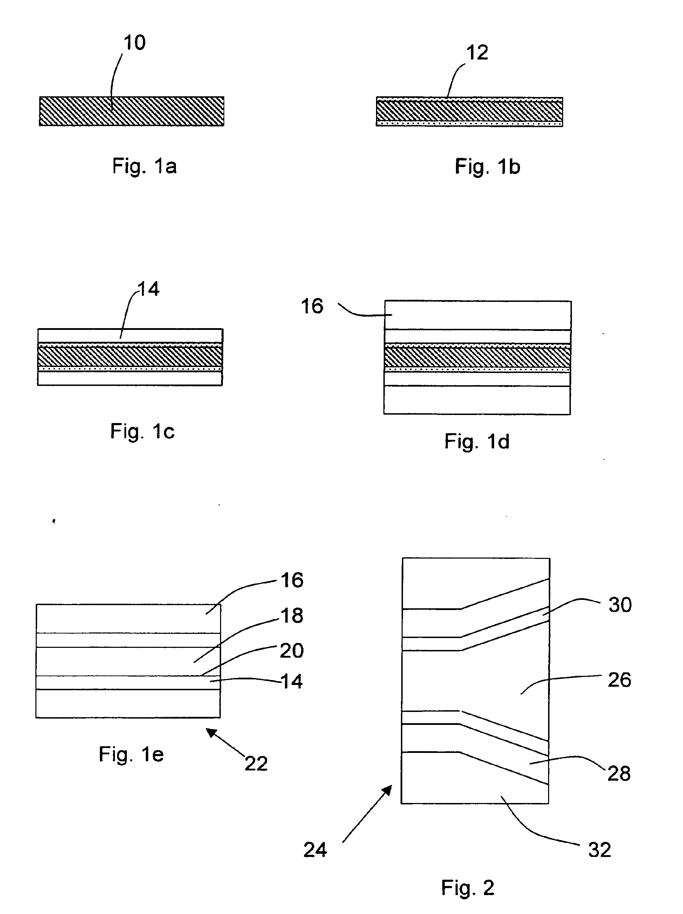

La première étape du procédé consiste à se doter d'une réplique sous la forme d'un filament 10, représenté sur la figure 1a, qui est avantageusement réalisé en un métal tel que le tantale, le niobium, le molybdène, le tungstène ou tout autre métal faisant partie des groupes IV B, V B ou VI B. Le filament a un diamètre correspondant à celui du canal interne du tube capillaire à réaliser. Typiquement, ce diamètre est de 0,1 à quelques dizaines de millimètres, selon l'application envisagée.

La suite du procédé va consister à déposer une couche de diamant sur le filament 10, selon une technique décrite en détail dans le brevet FR 2 790 267 et dont on se contentera donc de rappeler les phases essentielles.

Il y a lieu, au préalable, de former à la périphérie du filament 10, une couche superficielle compacte 12, montrée à la figure 1b, constituant une barrière destinée à éviter que le métal diffuse dans le film de diamant polycristallin dont il sera recouvert et le déstructure en graphite ou carbone amorphe. Typiquement, cette couche a une épaisseur comprise entre 0.1 et 10 µm.

La couche superficielle 12 peut être un nitrure, un carbure, un empilement de nitrure et de carbure, un carbonitrure (CN) ou du nitrure de bore (BN). La formation de ces couches fait appel à des techniques bien connues de l'homme de métier ou exposées dans le document FR déjà cité, qui nécessitent de chauffer le filament 10 à une température de l'ordre de 600 à 1300 °C selon le métal, ou composé, dont il est constitué.

L'opération suivante, illustrée par la figure 1c, est la formation, sur la couche barrière 12, de la couche de diamant polycristallin 14 déjà mentionnée.

Il est nécessaire, tout d'abord, d'ancrer des particules (ou germes) de diamant dans la couche superficielle 12, en utilisant des techniques connues. On peut ainsi procéder à un polissage ou à un sablage à l'aide d'une poudre de diamant dans de l'eau, de l'alcool éthylique ou de l'alcool isopropylique, dont les particules, de 1 nm à 1 µm de diamètre, formeront des germes pour la croissance du diamant. On peut également procéder à un traitement par ultrasons dans une suspension de poudre de diamant dans de l'eau, de l'alcool éthylique ou de l'alcool isopropylique. Des résultats particulièrement favorables sont obtenus avec une densité de germes comprise entre 10¹⁰ et 10¹³ par cm².

Le filament 10, doté de sa couche de particules de diamant, est alors placé en atmosphère de gaz réactif, par exemple de méthane et d'hydrogène, sous une pression réduite d'environ 10 à 100 mbars, à une température typiquement comprise entre 600 et 900°C. Dans ces conditions, les germes de diamant se mettent à croître, formant la couche de structure compacte et homogène 14. Son épaisseur peut, selon l'application visée, être comprise entre 0,05 et 50 µm.

Ensuite, comme illustré par la figure 1d, la couche de diamant 14 reçoit, à son tour, une couche 16 de céramique SiC/Si/Si₃N₄ ou un composé quelconque de Si, N et C, destinée à la renforcer mécaniquement. La couche 16 a, typiquement, une épaisseur de l'ordre de 0,5 à 10 mm. Son dépôt s'effectue, selon les techniques connues de l'homme de métier, à une température modérée, comprise entre 700 et 1000 °C, ce qui permet d'obtenir une finesse de grain garantissant une très bonne adhérence à la couche de diamant 14.

Il est important de noter que, selon l'invention, la couche barrière 12, la couche de diamant 14 et la couche de céramique 16 sont avantageusement formées en utilisant la technique du HFCVD (Hot Filament Chemical Vapor Deposition), selon laquelle les conditions de température nécessaires sont obtenues par chauffage du filament 10 lui-même, par effet Joule en faisant passer à travers lui un courant électrique d'intensité appropriée.

Comme schématisé sur la figure 1 e, l'opération suivante est la dissolution chimique du filament 10 et de sa couche protectrice 12 pour former un canal interne 18. A cet effet, une solution réactive, par exemple de l'eau régale, est simplement mise à circuler au contact du filament, pendant le temps nécessaire à sa dissolution complète.

Finalement, la paroi 20 du canal 18 reçoit avantageusement un traitement de surface pour parfaire sa finition et/ou la fonctionnaliser. Par fonctionnalisation de la surface, on entend un traitement, tel que fluoration, oxydation, hydrogénation, etc., destiné à rendre celle-ci hydrophobe ou hydrophile, dépendant de l'application envisagée.

Ainsi est obtenu un tube capillaire en céramique 22 dont le canal interne 18 est doté d'un revêtement en diamant 14 parfaitement lisse, car réalisé préalablement à sa base céramique, et résistant à tous les types de produits analysés, indépendamment de leur valeur de pH.

La figure 2 montre que le procédé selon l'invention permet aussi de réaliser, en 24, une filière d'extrusion ou de tréfilage ou une buse de découpage par jet d'eau.

Dans ce cas, le filament 10 est simplement remplacé par une pièce ayant la forme du canal interne 26 que l'on souhaite obtenir. Le procédé utilisé est alors identique à celui qui vient d'être décrit et aboutit, par exemple, à un entonnoir en céramique 28 dont la paroi interne est dotée d'un revêtement en diamant 30 à la fois parfaitement lisse et résistant. Bien entendu, pour assurer sa résistance mécanique, l'entonnoir doit être finalement chassé dans un support métallique 32, en acier ou en laiton, de forme appropriée. Toute autre forme qu'un entonnoir peut également être utilisée comme réplique en vue de réaliser, par exemple, un canal débouchant sur une chambre de forme quelconque.

Ainsi est proposé un procédé pour la fabrication de pièces tubulaires avec un revêtement interne de diamant qui, non seulement, est de forme et d'épaisseur très bien contrôlées, mais est aussi extrêmement résistant et parfaitement lisse.

## Revendications

1. Procédé de fabrication d'une pièce tubulaire (22, 32) formant un canal (18, 26) revêtu de diamant, **caractérisé en ce qu**'il consiste à se doter d'une réplique (10) dudit canal puis à effectuer les opérations de :
- dépôt d'une couche de diamant (14, 30) sur ladite réplique,
- dépôt d'une couche de céramique (16, 28) sur ladite couche de diamant, puis
- dissolution chimique de ladite réplique pour libérer ledit canal (18, 26).

2. Procédé selon la revendication 1, **caractérisé en ce que** ladite réplique (10) est en un métal choisi parmi le tantale, le niobium, le molybdène et le tungstène ou faisant partie d'un des groupes IV B, V B ou VI B.

3. Procédé selon l'une des revendications 1 et 2, **caractérisé en ce que,** préalablement au dépôt de la couche de diamant, ladite réplique (10) est soumise à une opération de nitruration et/ou carburation destinée à former une couche superficielle (12) constituant une barrière destinée à éviter que le matériau de ladite réplique diffuse dans la couche de diamant (14, 30) dont il sera recouvert et le déstructure en graphite ou carbone amorphe.

4. Procédé selon la revendication 3, **caractérisé en ce que** ladite couche barrière (12) a une épaisseur comprise entre 0.1 et 10 µm.

5. Procédé selon la revendication 3, **caractérisé en ce que** l'opération de nitruration et/ou carburation est suivie d'une opération destinée à faciliter l'ancrage du diamant dans ladite couche barrière (12).

6. Procédé selon l'une des revendications 1 à 5, **caractérisé en ce que** ladite couche de diamant (14, 30) est formée par croissance de germes en atmosphère de gaz réactif.

7. Procédé selon l'une des revendications 1 à 6, **caractérisé en ce que** ladite couche de diamant (14, 30) a une épaisseur comprise entre 0,05 et 50 µm.

8. Procédé selon l'une des revendications 1 à 7, **caractérisé en ce que** ladite couche de céramique (16, 28) est un composé quelconque de Si, N et C.

9. Procédé selon l'une des revendications 3, 6 et 8, **caractérisé en ce que**, lors de la formation de ladite couche barrière (12) et/ou de ladite couche de diamant (14, 30) et/ou de ladite couche de céramique (16, 28), la réplique (10) est chauffée par effet Joule.

10. Procédé selon l'une des revendications 1 à 10, **caractérisé en ce qu**'après l'opération de dissolution de ladite réplique (10), la paroi dudit canal (18, 26) subit un traitement de surface destiné à parfaire sa finition et/ou sa fonctionnalisation.

11. Procédé selon la revendication 10, **caractérisé en ce que** ledit traitement de surface est effectué par un traitement réactif en phase gazeuse.

12. Procédé selon l'une des revendications 1 à 11, **caractérisé en ce que** ladite pièce (22, 32) est finalement chassée dans un support de protection (32).

## Claims

1. Process for producing a tubular part (22, 32) forming a diamond-coated channel (18, 26), **characterized in that** it consists in providing a replica (10) of said channel and then in carrying out the operations of:
- depositing a diamond layer (14, 30) on said replica;
- depositing a ceramic layer (16, 28) on said diamond layer; and then
- chemically dissolving said replica in order to free said channel (18, 26).

2. Process according to Claim 1, **characterized in that** said replica (10) is made of a metal chosen from tantalum, niobium, molybdenum and tungsten, or a metal belonging to one of the groups IVB, VB or VIB.

3. Process according to either of Claims 1 and 2, **characterized in that**, prior to the deposition of the diamond layer, said replica (10) is subjected to a nitriding and/or carburizing operation intended to form a surface layer (12) constituting a barrier for preventing the material of said replica from diffusing into the diamond layer (14, 30), with which it will be covered, and from destructuring it into graphite or amorphous carbon.

4. The process as claimed in Claim 3, **characterized in that** said barrier layer (12) has a thickness between 0.1 and 10 µm.

5. Process according to Claim 3, **characterized in that** the nitriding and/or carburizing operation is followed by an operation intended for making it easier for the diamond to be anchored into said barrier layer (12).

6. Process according to one of Claims 1 to 5, **characterized in that** said diamond layer (14, 30) is formed by the growth of nuclei in a reactive gas atmosphere.

7. Process according to one of Claims 1 to 6, **characterized in that** said diamond layer (14, 30) has a thickness between 0.05 and 50 µm.

8. Process according to one of Claims 1 to 7, **characterized in that** said ceramic layer (16, 28) is any compound of Si, N and C.

9. Process according to one of Claims 3, 6 and 8, **characterized in that**, during formation of said barrier layer (12) and/or said diamond layer (14, 30) and/or said ceramic layer (16, 28), the replica (10) is heated by Joule heating.

10. Process according to one of Claims 1 to 10, **characterized in that**, after the operation of dissolving said replica (10), the wall of said channel (18, 26) undergoes a surface treatment intended to perfect its finish and/or its functionalization.

11. Process according to Claim 10, **characterized in that** said surface treatment is carried out by a reactive gas-phase treatment.

12. Process according to one of Claims 1 to 11, **characterized in that** said part (22, 32) is finally driven into a protective support (32).

## Patentansprüche

1. Verfahren zum Herstellen eines röhrenförmigen Teils (22, 32), das einen Kanal (18, 26) bildet, der mit Diamant beschichtet ist, **dadurch gekennzeichnet, dass** es darin besteht, einen Abdruck (10) des Kanals zu schaffen und dann die folgenden Operationen auszuführen:
- Ablagern einer Diamantschicht (14, 30) auf dem Abdruck,
- Ablagern einer Keramikschicht (16, 28) auf der Diamantschicht und dann
- chemisches Zersetzen des Abdrucks, um den Kanal (18, 26) freizugeben.

2. Verfahren nach Anspruch 1, **dadurch gekennzeichnet, dass** der Abdruck (10) aus einem Metall besteht, das aus Tantal, Niobium, Molybdän und Wolfram gewählt ist oder zu einer der Gruppen IV B, V B oder VI B gehört.

3. Verfahren nach einem der Ansprüche 1 und 2, **dadurch gekennzeichnet, dass** vor dem Ablagern der Diamantschicht der Abdruck (10) einem Nitrierhärtungs- und/oder Carburierungsvorgang unterworfen wird, der dazu vorgesehen ist, eine Oberflächenschicht (12) zu bilden, die eine Sperre bildet, die dazu vorgesehen ist zu vermeiden, dass das Material des Abdrucks in die Diamantschicht (14, 30), mit der es bedeckt wird, diffundiert und sie in Graphit oder amorphen Kohlenstoff destrukturiert.

4. Verfahren nach Anspruch 3, **dadurch gekennzeichnet, dass** die Sperrschicht (12) eine Dicke im Bereich von 0,1 bis 10 µm hat.

5. Verfahren nach Anspruch 3, **dadurch gekennzeichnet, dass** dem Nitrierhärtungs- und/oder Carburierungsvorgang ein Vorgang folgt, der dazu vorgesehen ist, die Verankerung von Diamant in der Sperrschicht (12) zu erleichtern.

6. Verfahren nach einem der Ansprüche 1 bis 5, **dadurch gekennzeichnet, dass** die Diamantschicht (14, 30) durch Wachstum von Keimen in einer reaktiven Gasatmosphäre gebildet wird.

7. Verfahren nach einem der Ansprüche 1 bis 6, **dadurch gekennzeichnet, dass** die Diamantschicht (14, 30) eine Dicke im Bereich von 0,05 bis 50 µm hat.

8. Verfahren nach einem der Ansprüche 1 bis 7, **dadurch gekennzeichnet, dass** die Keramikschicht (16, 28) eine beliebige Zusammensetzung aus Si, N und C ist.

9. Verfahren nach einem der Ansprüche 3, 6 und 8, **dadurch gekennzeichnet, dass** bei der Bildung der Sperrschicht (12) und/oder der Diamantschicht (14, 30) und/oder der Keramikschicht (16, 28) der Abdruck (10) durch den Joule-Effekt erhitzt wird.

10. Verfahren nach einem der Ansprüche 1 bis 10, **dadurch gekennzeichnet, dass** nach dem Zersetzungsvorgang des Abdrucks (10) die Wand des Kanals (18, 26) einer Oberflächenbearbeitung unterworfen wird, die dazu vorgesehen ist, ihre Endbearbeitung und/oder ihre Funktionalisierung zu vervollkommnen.

11. Verfahren nach Anspruch 10, **dadurch gekennzeichnet, dass** die Oberflächenbearbeitung durch eine reaktive Bearbeitung in der Gasphase ausgeführt wird.

12. Verfahren nach einem der Ansprüche 1 bis 11, **dadurch gekennzeichnet, dass** das Teil (22, 32) schließlich in einen Schutzträger (32) eingetrieben wird.
